# EUROPÄISCHE PATENTANMELDUNG

(11) **EP 1 132 973 A1**
(43) Veröffentlichungstag der Anmeldung: **12.09.2001**
(21) Anmeldenummer: 00104821.4
(22) Anmeldetag: 06.03.2000
(51) Int. Cl.: H01L 29/92

(54) **Metall-Isolator-Metall-Kondensator und Verfahren zu seiner Herstellung**

(71) Anmelder: Infineon Technologies AG, 81669 München (DE)
(72) Erfinder: Schrenk, Michael, 86911 Diessen (DE); Schwerd, Markus, 83607 Holzkirchen (DE); Lachner, Rudolf,Dr., 85051 Ingolstadt (DE)
(74) Vertreter: Zimmermann & Partner

(57) **Zusammenfassung**

Ein Kondensatorstapel (12) in einer Schichtstruktur eines integrierten Bauelements weist mit Ausnahme einer dielektrischen Zwischenschicht (5) die gleiche Schichtfolge wie eine benachbarte Leiterbahn (13) auf. Dadurch wird die Herstellung von Vias (16) wesentlich erleichtert.

## Beschreibung

Die Erfindung betrifft ein integriertes Bauelement mit einer Vielzahl von Leiterbahnen und einem Kondensator, wobei der Kondensator eine erste Elektrode, eine dielektrische Zwischenschicht und eine zweite Elektrode aufweist.

Die Erfindung betrifft ferner ein Verfahren zur Herstellung eines derartigen integrierten Bauelements.

Aus dem Artikel von Aryon Kar-Roy et al., "High Density Metal Insulator Metal Capacitor Using PECVD Nitride for Mixed Signal and RF Circuits", IITC, 1999, Seiten 245 bis 247, ist eine Halbleiterstruktur bekannt, bei der der Metall-Isolator-Metall-Kondensatoren von einer ersten Metallschicht, einer dielektrischen Zwischenschicht und einer Zwischenmetallschicht gebildet ist. Die Zwischenmetallschicht ist über Vias an eine zweite Metallschicht angeschlossen. Die erste und die zweite Metallschicht bilden auch die Leiterbahnen, durch die die passiven Bauelemente in der Schichtstruktur untereinander verbunden werden. Dementsprechend verläuft die erste Metallschicht und die zweite Metallschicht über den gesamten Querschnitt der Halbleiterstruktur hinweg im wesentlichen auf gleichem Niveau. Die Zwischenmetallschicht, die eine der Elektroden des Kondensators bildet, ist jedoch in ihrer Ausdehnung örtlich begrenzt und ist auf einem Niveau zwischen der ersten und zweiten Metallschicht angeordnet.

Zur Herstellung der bekannten Schichtstruktur wird zunächst auf die die erste Elektrode des Kondensators bildende erste Metallschicht aus Aluminium eine Schicht aus Ti oder TiN aufgebracht. Auf dieser Schicht wird anschließend die dielektrische Zwischenschicht, beispielsweise aus SiO₂ oder SiN, abgeschieden. Daraufhin wird in dieser Reihenfolge zunächst eine Schicht aus Ti oder TiN, die Zwischenmetallschicht aus Aluminium und eine weitere Schicht aus Ti oder TiN, die als Antireflexionsschicht dient, aufgebracht. Das Aufbringen der genannten Schichten erfolgt ganzflächig. Zum Strukturieren der die zweite Elektrode bildenden zweiten Metallschicht wird auf der Antireflexionsschicht ein Photolack aufgebracht und belichtet. Anschließend wird mit Stop in der dielektrischen Zwischenschicht geätzt. Daran schließt sich eine Strukturierung der die erste Elektrode bildenden, darunterliegenden ersten Metallschicht an. Zu diesem Zweck wird erneut ein Photolack aufgebracht, belichtet und anschließend die erste Metallschicht geätzt. Dadurch entsteht eine Schichtstruktur mit einem Kondensator, dessen erste Elektrode von der ersten Metallschicht und dessen zweite Elektrode von der Zwischenmetallschicht gebildet ist.

Ein Nachteil der bekannten Schichtstruktur und des Verfahrens zu seiner Herstellung ist, daß die Herstellung von Vias zwischen der Zwischenmetallschicht und der zweiten Metallschicht schwierig ist. Denn bei diesem Prozeßschritt werden zweckmäßigerweise auch die Vias zwischen den Leiterbahnen in der ersten Metallschicht und den Leiterbahnen der zweiten Metallschicht hergestellt. Die Vias zwischen der Zwischenmetallschicht und der zweiten Metallschicht haben jedoch eine geringere Tiefe als die Vias zwischen Leiterbahnen in der ersten Metallschicht und Leiterbahnen der zweiten Metallschicht. Folglich muß die Zwischenmetallschicht wirksam durch einen Ätzstop geschützt werden. Dies läßt sich jedoch nicht immer bewerkstelligen. Demnach kommt es häufig zur Zerstörung der Zwischenmetallschicht und damit des Kondensators.

Ausgehend von diesem Stand der Technik liegt der Erfindung die Aufgabe zugrunde, ein auf einfache Art und Weise herstellbares integriertes Bauelement mit einem Metall-Isolator-Metall-Kondensator zu schaffen und ein Verfahren zu seiner Herstellung anzugeben.

Diese Aufgabe wird durch ein integriertes Bauelement nach Anspruch 1 und ein Verfahren nach Anspruch 10 gelöst.

Da die Elektroden des Kondensators zusammen im wesentlichen die gleiche Schichtfolge wie die Schichtfolge der nächstliegenden Leiterbahn aufweisen, unterscheidet sich die Schichtfolge im Bereich des Kondensators nur durch die dielektrische Zwischenschicht von der Schichtfolge im Bereich der Leiterbahnen. Folglich weisen die Vias zwischen der zweiten Elektrode und einer darüberliegenden Metallschicht und die Vias zwischen der benachbarten Leiterbahn und der darüberliegenden Metallschicht im wesentlichen die gleiche Länge auf. Außerdem entspricht die Dicke der Elektroden in etwa der Dicke einer Leiterbahn. Üblicherweise weisen Leiterbahnen jedoch im Vergleich zu sonstigen Schichten eine sehr hohe Dicke auf. Da beim Gegenstand gemäß der Erfindung die Elektroden in etwa die Dicke einer Leiterbahn aufweisen, ist es nicht von Nachteil, wenn die zweite Elektrode beim Ausätzen der Vias angeätzt wird. Denn aufgrund ihrer großen Dicke weist die verbleibende zweite Elektrode immer noch eine für ihre Funktion ausreichende Dicke auf. Aus diesen Gründen muß die zweite Elektrode auch nicht durch einen wirksamen Ätzstop beim Ätzen der Kanäle für die Vias geschützt werden.

Das Herstellverfahren zur Herstellung des Kondensators wird zweckmäßigerweise so geführt, daß zunächst die untere erste Elektrode und die dielektrische Zwischenschicht abgeschieden und strukturiert werden. Auf die so ausgebildete untere erste Elektrode können die zur Ausbildung der zweiten Elektrode erforderlichen Schichten aufgebracht werden. Nach der Strukturierung dieser Schichten ergibt sich schließlich ein Kondensator, dessen Elektroden zusammen die gleiche Schichtfolge aufweisen, wie eine zusammen mit dem Kondensator geformte Leiterbahn. Wie bereits erwähnt, wird dadurch die Herstellung der Vias zwischen der zweiten Elektrode und einer darüberliegenden Metallschicht und zwischen benachbarten Leiterbahnen und der darüberliegenden Metallschicht wesentlich erleichtert.

Zweckmäßige Ausgestaltungen der Erfindung sind Gegenstand der abhängigen Ansprüche.

Nachfolgend wird ein Ausführungsbeispiel der Erfindung im einzelnen anhand der beigefügten Zeichnung erläutert. Es zeigen:
- Figur 1: einen Querschnitt durch eine Schichtstruktur, bei der bereits die erste Elektrode strukturiert worden ist;
- Figur 2: einen Querschnitt durch eine Schichtstruktur, bei der bereits die zweite Elektrode strukturiert worden ist, und
- Figur 3: einen Querschnitt durch die fertige Schichtstruktur.

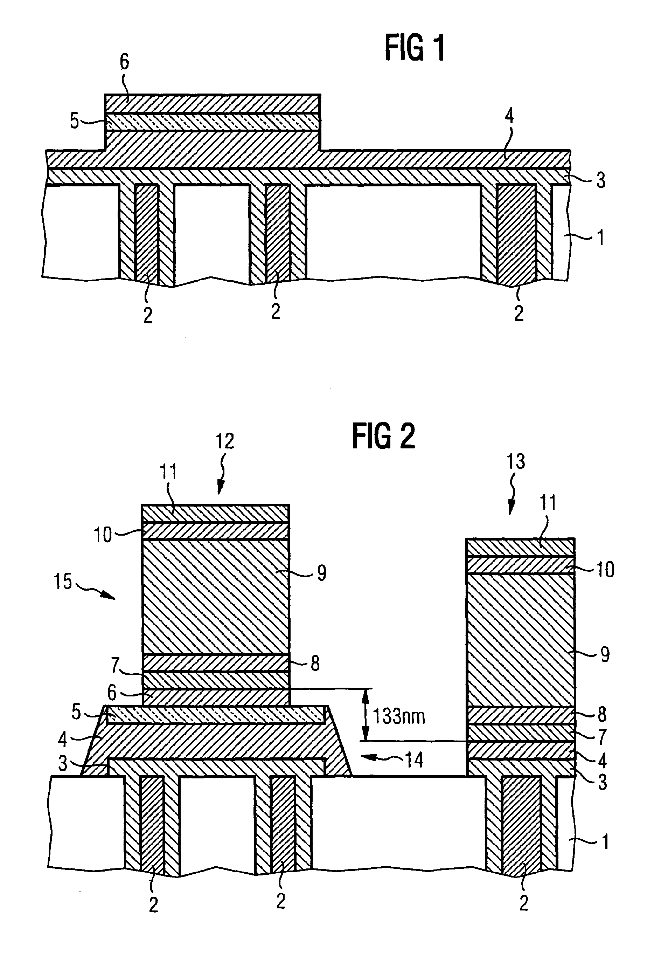

Die Figuren 1 und 2 stellen Querschnitte zu verschiedenen Zeitpunkten durch das sich im Herstellungsvorgang befindende integrierte Bauelement dar.

Figur 1 stellt einen Querschnitt durch einen Bereich des integrierten Bauelements dar, in dem ein Kondensator ausgebildet werden soll. Zu diesem Zweck wird auf ein Zwischenlagendielektrikum 1, das Vias 2 aufweist, eine erste Metallisierungsschicht 3 ganzflächig aufgebracht. Die Vias 2 führen zu einer in Figur 1 nicht dargestellten, unter dem Zwischenlagendielektrikum 1 angeordneten ersten Metallschicht, in der Leiterbahnen ausgebildet sind. Auf die erste Metallisierungsschicht 3 werden dann nacheinander eine als Diffusionsbarriere dienende erste Getterschicht 4, eine dielektrische Zwischenschicht 5 und eine Antireflexionsschicht 6 ganzflächig aufgebracht. Zur Strukturierung der dielektrischen Zwischenschicht 5 wird die Antireflexionsschicht 6 mit einem Photolack versehen, der anschließend belichtet wird. Daran schließt sich ein Ätzvorgang mit Stop in der ersten Getterschicht 4 an. Daraufhin wird der Photolack auf der Antireflexionsschicht 6 entfernt, wobei die Antireflexionsschicht 6 die dieleketrische Zwischenschicht schützt. Danach wird eine zweite Getterschicht 7, eine erste Antidegradationsschicht 8, eine zweite Metallschicht 9, eine zweite Antidegradationsschicht 10 und eine zweite Antireflexionsschicht 11 ganzflächig aufgebracht. Anschließend erfolgt die Strukturierung mit Hilfe eines Photolacks auf der zweiten Antireflexionsschicht 11 und einem nachfolgenden Ätzen mit Stop auf dem Zwischenlagendielektrikum 1. Dadurch entsteht in dem in Figur 2 dargestellten Ausschnitt ein Kondensatorstapel 12 und eine benachbarte Leiterbahn 13. Bei der Leiterbahn 13 soll es sich um die nächstliegende Leiterbahn handeln. Der Kondensatorstapel 12 enthält einen Kondensator, der eine erste Elektrode 14 aus der ersten Metallisierungsschicht 3 und der ersten Getterschicht 4 aufweist. Die Antireflexionsschicht 6, die zweite Getterschicht 7, die erste Antidegradationsschicht 8, die zweite Metallschicht 9, die zweite Antidegradationsschicht 10 und die zweite Antireflexionsschicht 11 bilden dagegen die zweite Elektrode 15. Zwischen der ersten Elektrode 14 und der zweiten Elektrode 15 befindet sich die dielektrische Zwischenschicht 5. Von der dielektrischen Zwischenschicht 5 abgesehen, weist der Kondensatorstapel 12 somit die gleiche Schichtenfolge wie die benachbarte Leiterbahn 13 auf.

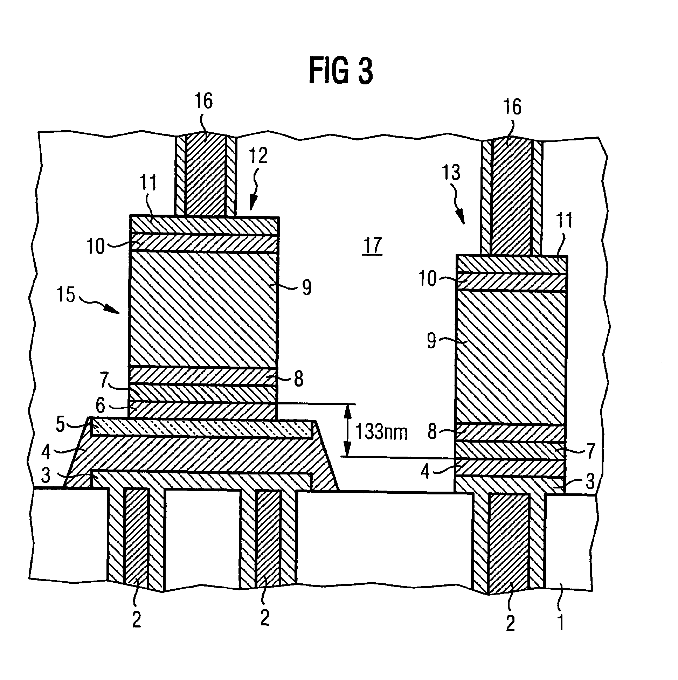

Nach der Ausbildung des Kondensatorstapels 12 und der Leiterbahn 13 werden beide in ein in Figur 3 dargestelltes zweites Zwischenlagendielektrikum 17 eingebettet. Die sich auf der Oberfläche des zweiten Zwischenlagendielektrikums 17 bildenden Unebenheiten werden anschließend eingeebnet. Daraufhin werden in dem zweiten Zwischenlagendielektrikum 17 Vias 16 ausgebildet, die die zweite Elektrode 15 mit einer in Figur 2 nicht dargestellten, darüberliegenden dritten Metallschicht verbinden sollen. Ebenso können zum Anschluß der Leiterbahn 13 Vias 16 ausgebildet werden, die die Leiterbahn 13 mit der darüberliegenden dritten Metallschicht verbinden. Da die Vias 16 in etwa die gleiche Tiefe aufweisen, sind keine besonderen Vorkehrungen erforderlich, um die zweite Elektrode 15 beim Ausätzen der Kanäle für die Vias 16 vor dem Ätzmedium zu schützen. Dazu trägt auch die große Schichtdicke der zweiten Metallschicht 9 bei. Denn selbst wenn das Ätzmedium in die zweite Metallschicht 9 im Kondensatorstapel 12 vordringt, so ist doch die zweite Metallschicht 9 ausreichend dick, um nicht vollständig zerstört zu werden. Daher ist die zweite Elektrode 15 auch nicht durch einen fehlerhaft ablaufenden Ätzvorgang gefährdet.

Ein weiterer Vorteil ist der räumliche Abstand der in den Figuren 1 bis 3 nicht dargestellten, unter dem ersten Zwischenlagendielektrikum 1 liegenden Metallschicht zu der ersten Elektrode 14. Denn auf der ersten Metallschicht können Unebenheiten auftreten, die eine dielektrische Zwischenschicht verwerfen, wenn die dielektrische Zwischenschicht unmittelbar auf die erste Metallschicht aufgebracht wird, was dann der Fall ist, wenn die erste Metallschicht als Elektrode dient. Gegenüber dieser aus dem Stand der Technik bekannten Anordnung unterscheidet sich die in den Figuren 1 bis 3 dargestellte Schichtstruktur durch die räumliche Trennung von erster Metallschicht und erster Elektrode 14. Da die erste Elektrode 14 auf einer beispielsweise durch chemisches mechanisches Polieren eingeebneten Oberfläche des Zwischenlagendielektrikums 1 aufgebracht wird, ist die erste Elektrode 14 im wesentlichen flach. Gleiches gilt für die auf der ersten Elektrode 14 aufgebrachte dielektrische Zwischenschicht 5. Die hier vorgestellte Schichtstruktur wahrt somit in besonderer Weise die Planarität von erster Elektrode 14, dielektrischer Schicht 5 und zweiter Elektrode 15.

Ein weiterer Vorteil ist in der vollständigen Entfernung der dielektrischen Schicht 5 außerhalb des Kondensatorstapels 12 zu sehen. Im Gegensatz zu der hier vorgestellten Schichtstruktur verbleiben beim Stand der Technik Reste der ganzflächig aufgebrachten dielektrischen Zwischenschicht außerhalb des Kondensatorstapels 12, da die dielektrische Zwischenschicht als Ätzstop verwendet wird. Die Reste der dielektrischen Zwischenschicht führen beim Stand der Technik aufgrund unterschiedlicher Ausdehnungskoeffizienten zwischen Resten der dielektrischen Zwischenschicht und den unmittelbar angrenzenden, darunterliegenden Metallschichten zu Spannungen. Diese treten insbesondere nach thermischen Behandlungen auf und beeinträchtigen die Zuverlässigkeit, denndiese Spannungen können so groß werden, daß Risse oder Aufwerfungen auftreten. Demgegenüber wird bei der Schichtstruktur in Figur 1 bis 3 und dem Verfahren zu seiner Herstellung die dielektrische Zwischenschicht 5 nicht als Ätzstop verwendet und außerhalb des Kondensatorstapels 12 vollständig entfernt. Demnach ist keine Verwerfung der darüberliegenden Schichten zu befürchten. Außerdem können auch Materialien mit großer Dielektrizitätkonstante > 50, wie beispielsweise Ta₂O₅, Bi₂Sr₃TiO₃ oder BaₓSr₁₋ₓTiO₃ verwendet werden, wobei 0≤ x ≤1 gilt. Da die Reste der dielektrischen Zwischenschicht außerhalb des Kondensatorstapels 12 vollständig entfernt werden, besteht nicht die Gefahr, daß Reste dieser Materialien die Streukapazität zwischen den Leiterbahnen in der ersten Metallschicht und der zweiten Metallschicht 9 erhöhen. Die Materialien mit hoher Dielektrizitätskonstante, können auch dann verwendet werden, wenn ihr Ätzverhalten nicht vollständig bekannt ist. Denn da die dielektrische Zwischenschicht 5 nicht als Ätzstop verwendet wird, kommt es auf das Ätzverhalten der für die dielektrische Zwischenschicht 5 verwendeten Materialien nicht an.

Wesentlich ist ferner, daß die erste Elektrode 14 und die zweite Elektrode in zwei getrennten Ätzvorgängen ausgeformt werden. Denn dadurch kann die erste Elektrode 14 und die dielektrische Zwischenschicht 5 breiter als die zweite Elektrode 15 ausgeführt werden. Kurzschlüsse zwischen der ersten Elektrode 14 und der zweiten Elektrode 15 treten dann kaum auf, und die Durchbruchsfertigkeit wird erhöht.

Ein weiterer Vorteil der Schichtstruktur besteht schließlich darin, daß die erste Antireflexionsschicht 6 und die zweite Antireflexionsschicht 11 vor dem Beschichten mit dem Photolack keinem Ätzvorgang ausgesetzt sind. Dadurch ist die Unversehrtheit der Antireflexionsschicht 6 und der zweiten Antireflexionsschicht 11 gewährleistet. Demnach kann die Belichtung des auf der Antireflexionsschicht 6 und der Antireflexionsschicht 8 aufgebrachten Photolacks ohne unerwünschte Reflexionen erfolgen. Dadurch wird die Qualität der Strukturierung verbessert.

Im Gegensatz zum Stand der Technik werden die erste Antireflexionsschicht 6 und die zweite Antireflexionsschicht 11 unmittelbar nach dem Aufbringen zur Lithographie verwendet, ohne daß Reste dielektrischer Schichten vorhanden sind, die das Reflexionsverhalten der ersten Antireflexionsschicht 6 und der zweiten Antireflexionsschicht 11 beim Belichten beeinträchtigen.

Bei der Ausführungsform aus den Figuren 1 bis 3 weist die erste Metallisierungsschicht eine Schichtdicke von etwa 44 nm auf. Daran schließt sich die erste Getterschicht 4 mit einer Schichtdicke von 100 nm. In der benachbarten Leiterbahn 13 beträgt die Schichtdicke der ersten Getterschicht 4 nur noch 50 +/- 30 nm, da die erste Getterschicht 4 während des Herstellvorgangs außerhalb des Kondensatorstapels heruntergeätzt wird. Auf der ersten Getterschicht 4 befindet sich die 50 nm dicke dielektrische Zwischenschicht 5. Daran schließt sich die erste Antireflexionsschicht 6 mit einer Dicke von 33 nm an. Letztere Schichten sind ausschließlich im Kondensatorstapel 12 vorhanden. Die darüberliegenden Schichten, nämlich die zweite Getterschicht 7 mit einer Dicke von 33 nm, die erste Antidegradationsschicht 8 mit einer Dicke von 20 nm, die zweite Metallschicht 9 mit einer Dicke von 400 nm und die zweite Antidegradtionsschicht 10 mit einer Dicke von 10 nm sowie die zweite Antireflexionsschicht 11 mit einer Dicke von 33 nm sind sowohl im Kondensatorstapel 12 als auch in der benachbarten Leiterbahn 13 vorhanden. Dadurch ergibt sich ein Höhenversatz von lediglich 133 nm zwischen dem Kondensatorstapel 12 und der benachbarten Leiterbahn 13. Ein derartiger Höhenversatz kann jedoch ohne Schwierigkeiten in eine Schichtstruktur mit mehreren durch Zwischenlagendielektrika getrennten Metallschichten integriert werden.

Bei dem Ausführungsbeispiel in Figur 1 bis 3 ist das Zwischenlagendielektrikum 1 und das Zwischenlagendielektrikum 14 von SiO₂ oder SiN gebildet. Für die erste Metallisierungsschicht 3, und die Antidegradationsschichten 8 und 10 ist Titan als Material vorgesehen. Die Getterschichten 4 und 7 sowie die Antireflexionsschichten 6 und 11 sind aus TiN hergestellt. Für die zweite Metallschicht 9 und die in den Figuren 1 bis 3 nicht dargestellte erste Metallschicht und die zweite Metallschicht 9 ist Aluminium vorgesehen.

Die genannten Materialien sind beispielhaft gemeint. Dabei kommen auch andere Materialien in Frage. Für die Metallschichten und Metallisierungsschichten kommen leitende Materialien wie Si, W, Cu, Ag, Au, Ti, Pt und Legierungen davon in Frage. Für die übrigen Schichten eignen sich neben Ti und TiN auch TiW, W, WNₓ mit 0 < x < 2, Ta, TaN und Silizide.

Als dielektrische Schichten eignen sich neben SiO₂ auch alle anderen Isolationsmaterialien wie beispielsweise Si₃N₄, Ta₂O₅ verwendet werden. Für das erste Zwischenlagendielektrikum 1 und das zweite Zwischenlagendielektrikum 17 werden bevorzugt SiO₂ oder organische Materialien sowie Materialien mit einer niedrigen Dielektrizitätskonstante verwendet.

Die in den Figuren 1 bis 3 dargestellte Schichtstruktur zeichnet sich durch eine hohe Spannungslinarität der Kondensatoren, und niedrige parasitäre Kapazitäten aus, was eine präzise Kontrolle der Kapazitätswerte ermöglicht. Damit eignet sich die in den Figuren 1 bis 3 dargestellte Schichtstruktur insbesondere für Anwendungen in der Hochfrequenztechnik

## Patentansprüche

1. Integriertes Bauelement mit einer Vielzahl von Leiterbahnen (13) und einem Kondensator (12), wobei der Kondensator (12) eine erste Elektrode (14), eine dielektrische Zwischenschicht (5) und eine zweite Elektrode (15) aufweist,
**dadurch gekennzeichnet,**
daß die Elektroden (14, 15) des Kondensators (12) zusammen eine Schichtfolge (3, 4, 7-11) aufweisen, die gleich der Schichtfolge (3, 4, 7-11) der nächstliegenden Leiterbahn (13) ist.

2. Integriertes Bauelement nach Anspruch 1,
**dadurch gekennzeichnet,**
daß die als Elektroden (14, 15) des Kondensators (12) dienenden Metallisierungsschichten (3, 8-10) die gleiche Dicke, wie die Metallisierungsschichten (3, 8-10) der nächstliegenden Leiterbahn (13) aufweisen.

3. Integriertes Bauelement nach Anspruch 2,
**dadurch gekennzeichnet,**
daß alle den Kondensator (12) bildenden Schichten bis auf eine unter der Zwischenschicht (5) liegende Schicht (4) die gleiche Dicke wie entsprechende Schichten der nächstliegenden Leiterbahn (13) aufweisen.

4. Integriertes Bauelement nach einem der Ansprüche 1 bis 3,
**dadurch gekennzeichnet,**
daß die zweite Elektrode (15) eine Metallschicht (9) mit einer Dicke zwischen 200 bis 600 nm aufweist.

5. Integriertes Bauelement nach Anspruch 4,
**dadurch gekennzeichnet,**
daß die Metallschicht (9) aus Aluminium gefertigt ist.

6. Integriertes Bauelement nach einem der Ansprüche 1 bis 5,
**dadurch gekennzeichnet,**
daß die erste Elektrode (14) eine Metallschicht mit einer Dicke zwischen 20 bis 60 nm aufweist.

7. Integriertes Bauelement nach Anspruch 6,
**dadurch gekennzeichnet,**
daß die erste Elektrode (14) aus Titan gefertigt ist.

8. Integriertes Bauelement nach einem der Ansprüche 1 bis 7,
**dadurch gekennzeichnet,**
daß die erste Elektrode (14) durch Vias (2) mit einer darunterliegenden Leiterbahnschicht aus Metall verbunden ist.

9. Integriertes Bauelement nach einem der Ansprüche 1 bis 8,
**dadurch gekennzeichnet,**
daß die zweite Elektrode (15) mit Hilfe von Vias (16) mit einer darüberliegenden Leiterbahnschicht aus Metall verbunden ist.

10. Verfahren zur Herstellung eines integrierten Bauelements, bei dem zur Ausbildung eines Kondensators (12) eine Metall-Isolator-Metall-Schichtfolge abgeschieden und strukturiert wird,
**dadurch gekennzeichnet,**
daß zunächst eine erste Schichtfolge (3, 4) für die erste Elektrode (14) und eine nachgeordnete Zwischenschicht (5) abgeschieden und anschließend mit Stop in der ersten Schichtfolge strukturiert werden und
daß dann zur Ausbildung der zweiten Elektrode (15) und von Leiterbahnen (13) eine zweite Schichtfolge (7, 8, 9, 10, 11) abgeschieden und strukturiert wird.

11. Verfahren nach Anspruch 10,
**dadurch gekennzeichnet,**
daß auf ein Zwischenlagendielektrikum (1), in dem Vias (2) ausgebildet sind, eine erste Metallisierungsschicht (3) ganzflächig abgeschieden wird.

12. Verfahren nach Anspruch 11,
**dadurch gekennzeichnet,**
daß auf die Metallisierungsschicht (3) eine erste Barriere (4), eine Zwischenschicht (5) aus einem Dielektrikum und eine Antireflexionsschicht (6) ganzflächig abgeschieden wird.

13. Verfahren nach Anspruch 12,
**dadurch gekennzeichnet,**
daß die erste Barriere (4), die Zwischenschicht (5) sowie die Antireflexionsschicht (6) zur Ausbildung eines Kondensatorsstapels (12) mit Stop in der ersten Barriere (4) strukturiert werden.

14. Verfahren nach Anspruch 13,
**dadurch gekennzeichnet,**
daß auf die Antireflexionsschicht (6) eine zweite Barriere (7), eine Metallschicht (9) und eine zweite Antireflexionsschicht (11) aufgebracht werden.

15. Verfahren nach Anspruch 14,
**dadurch gekennzeichnet,**
daß die zweite Barriere (7), die Metallschicht (9) sowie die zweite Antireflexionsschicht (11 bis hinunter auf das Zwischenlagendielektrikum (1) strukturiert werden.
